# EUROPEAN PATENT APPLICATION

(11) **EP 3 556 902 A1**
(43) Date of publication of application: **23.10.2019**
(21) Application number: 17879779.1
(22) Date of filing: 21.11.2017
(51) Int. Cl.: C23C 14/34, C23C 14/54

(54) **SHUTTER MECHANISM FOR TARGET, AND FILM-FORMING DEVICE PROVIDED WITH SAME**

(30) Priority: 14.12.2016 JP 2016241916
(71) Applicant: Kabushiki Kaisha Kobe Seiko Sho (Kobe Steel, Ltd.), Kobe-shi, Hyogo 651-8585 (JP)
(72) Inventor: OHBA, Naoki, Takasago-shi, Hyogo 676-8670 (JP)
(74) Representative: TBK
(86) International application number: PCT/JP2017/041898
(87) International publication number: WO 2018/110225

(57) **Abstract**

Provided is a shutter mechanism for opening and closing a substrate-facing surface (30) of a target (3). The shutter mechanism is provided with: a shutter (6) having first and second shutter plates (11A, 11B) having first and second edge parts (30a, 30b), respectively; and first and second rotary support parts (13A, 13B) for supporting the first and second shutter plates (11A, 11B) so as to be able to rotate about first and second rotary shafts (SA, SB) extending in the direction of a line normal to the substrate-facing surface (30) so that the first and second shutter plates (11A, 11B) can move between an open position and a closed position at which the first and second edge parts (30a, 30b) overlap. The first and second rotary shafts (13A, 13B) are disposed so as to be divided toward both sides with an overlap region of the first and second edge parts (30a, 30b) therebetween so that the first and second edge parts (30a, 30b) in the open position thereof extend along sides of the substrate-facing surface (30).

## Description

### TECHNICAL FIELD

The present invention relates to a target shutter mechanism for openably covering a target used for sputtering and a film-forming device including the target shutter mechanism.

### BACKGROUND ART

In a film-forming device configured to form a film on a substrate surface by sputtering, in the case of separately performing a film formation process by means of multiple targets made of different materials, shutter mechanisms each including shutters configured to separately cover the multiple targets need to be provided to reduce contamination of a surface of an unused target due to particles released from other targets. The shutter mechanism for covering the target as described above can be used for pre-sputtering. Such pre-sputtering is the step of removing contamination adhering to the surface of the target, and is performed before the film formation process using the targets. Such pre-sputtering is performed in such a manner that particles of a substance on the surface of the target are released by voltage application to the target in a state in which the target is covered with the shutter to minimize film adherence to a substrate. Thus, in any of the film formation process and the pre-sputtering as described above, contamination easily adheres to the shutter.

A shutter mechanism described in Patent Document 1 has been known as a shutter mechanism mounted on a typical film-forming device. The shutter mechanism includes a rotary shaft and a shutter plate. The rotary shaft extends in a direction along a surface (hereinafter referred to as a "target surface") of a target facing a substrate. The shutter plate is configured to swing in a direction from the target to the substrate about the rotary shaft or an opposite direction to open or close the target.

In this shutter mechanism, there is a probability that when the shutter plate operates in an open direction, i.e., a direction toward the substrate, pieces of contamination adhering to the shutter plate are detached and adhere to the substrate. Such contamination adherence to the substrate is a cause for a defect of a film formed on the substrate and film contact failure. Moreover, the shutter mechanism needs a space for opening or closing the shutter plate between the target and the substrate, and for this reason, it is difficult to reduce the size of the film-forming device.

The technique of solving the problem on substrate contamination and the problem on the installation space of the shutter mechanism may include a technique in which the shutter plate is moved in a direction along the target surface, i.e., a direction parallel with the target surface, not to approach the substrate to open or close the target.

For example, Patent Document 2 discloses a shutter mechanism mounted on a sputtering device. The shutter mechanism includes a shutter having a larger area than the area of a target surface to cover the entirety of the target surface, and a movement mechanism configured to move the shutter between a closed position at which the shutter covers the target surface and an open position at which the shutter is separated from the target surface in a direction along the target surface. The movement mechanism has a rotary shaft portion extending in a normal direction of the target surface at a position deviating from the target surface and configured rotatable about its own axis, and an arm fixed to a tip end of the rotary shaft portion and extending in the direction along the target surface. The arm has a tip end rotatable about the rotary shaft portion, and the shutter is fixed to such a tip end. The rotary shaft portion is movable along the normal direction, and by such movement, the shutter can be linearly moved in a direction toward the target surface or a direction apart from the target surface. Further, the shutter and the arm can rotate, together with the rotary shaft portion, about the rotary shaft portion in the direction along the target surface. The movement mechanism linearly moves the shutter at the closed position apart from the target surface in the normal direction of the target surface, and thereafter, rotates the shutter about the rotary shaft portion in the direction along the target surface. In this manner, the shutter can be retracted to the open position laterally separated from the target surface.

However, the shutter mechanism described in Patent Document 2 causes, for moving the shutter covering the entirety of the target surface from the closed position to the open position, the shutter to perform both of linear movement in the direction apart from the target surface and rotation about the rotary shaft portion. Thus, a retracting space for receiving the shutter is necessary at the side of the target, and needs to have a larger area than that of the target surface. This interferes with size reduction in a film-forming device. In other words, due to size reduction in the film-forming device, it is difficult to ensure the retracting space at the periphery of the target in a vacuum chamber.

Moreover, the shutter mechanism requires a complicated structure for both of linear movement and rotation described above. This increases the probability that operation failure of the shutter mechanism is caused due to, e.g., adherence of film pieces to the movement mechanism, the film pieces being generated in a film formation process.

### CITATION LIST

### PATENT DOCUMENT

Patent Document 1: JP 5-339725 A
Patent Document 2: JP 2009-155706

### SUMMARY OF THE INVENTION

An object of the present invention is to provide a target shutter mechanism including a shutter configured to openably cover a target used for sputtering, the target shutter mechanism being configured so that a retracting space for retracting the shutter from the target to an open position can be narrowed without the need for a complicated structure.

Provided is a shutter mechanism for openably covering a target used for sputtering and having a substrate-facing surface facing a substrate on which a film is formed by sputtering. The shutter mechanism includes a shutter configured movable in a direction along the substrate-facing surface at a position between the substrate-facing surface and the substrate and having a first shutter plate and a second shutter plate, the first shutter plate and the second shutter plate each having a first edge portion and a second edge portion contactable each other or approachable to each other at the position between the substrate-facing surface and the substrate; a first rotary support portion configured to support the first shutter plate such that the first shutter plate is rotatable about a first rotation axis extending in a normal direction of the substrate-facing surface; a second rotary support portion configured to support the second shutter plate such that the second shutter plate is rotatable about a second rotation axis extending in the normal direction of the substrate-facing surface; and a drive device configured to rotatably drive the first shutter plate and the second shutter plate about the first rotation axis and the second rotation axis. The first rotary support portion and the second rotary support portion rotatably support the first shutter plate and the second shutter plate such that transition is, by rotation of the first shutter plate and the second shutter plate about the first rotation axis and the second rotation axis, made between a closed position at which the first shutter plate and the second shutter plate close the substrate-facing surface with the first edge portion and the second edge portion contacting each other or being close to each other at the position between the substrate-facing surface and the substrate and an open position at which the substrate-facing surface is opened to the substrate in such a manner that each of the first shutter plate and the second shutter plate retracts from the position between the substrate-facing surface and the substrate such that the first edge portion and the second edge portion are separated from each other. The first rotation axis and the second rotation axis are arranged on both sides of a closed position edge region such that the first edge portion and the second edge portion are along at least part of an outer peripheral edge of the substrate-facing surface at the open position, the closed position edge region being a region where the first edge portion and the second edge portion contact each other or are close to each other when the first shutter plate and the second shutter plate are at the closed position.

### BRIEF DESCRIPTION OF DRAWINGS

Fig. 1 is a sectional plan view of a film-forming device including a target shutter mechanism according to an embodiment of the present invention.
Fig. 2 is a front sectional view along the line II-II of Fig. 1.
Fig. 3 is a side sectional view along the line III-III of Fig. 2.
Fig. 4 is an enlarged plan view in a state in which first and second edge portions of first and second shutter plates in the shutter mechanism illustrated in Fig. 1 overlap with each other.
Fig. 5 is a front view in a state in which the first and second shutter plates are at a closed position with respect to a target having a rectangular substrate-facing surface.
Fig. 6 is a front view in a state in which the first and second shutter plates are at a closed position with respect to the target.
Fig. 7 is a front view of preferable positions of a first rotation axis and a second rotation axis of the shutter mechanism with respect to the target.
Fig. 8 is a front view of a target shutter mechanism according to a second embodiment of the present invention.
Fig. 9 is, in the case of covering a substrate-facing surface of a target having the square substrate-facing surface, a front view of a first example regarding the position of the second rotation axis relative to the target and the corresponding open position of the second shutter plate in the target shutter mechanism according to the first embodiment.
Fig. 10 is, in the case of covering the substrate-facing surface of the target having the square substrate-facing surface, a front view of a second example regarding the position of the second rotation axis relative to the target and the corresponding open position of the second shutter plate in the target shutter mechanism according to the first embodiment.
Fig. 11 is, in the case of covering the substrate-facing surface of the target having the square substrate-facing surface, a front view of a third example regarding the position of the second rotation axis relative to the target and the corresponding open position of the second shutter plate in the target shutter mechanism according to the first embodiment.
Fig. 12 is, in the case of covering the substrate-facing surface of the target having the square substrate-facing surface, a front view of a fourth example regarding the position of the second rotation axis relative to the target and the corresponding open position of the second shutter plate in the target shutter mechanism according to the first embodiment.
Fig. 13 is, in the case of covering the substrate-facing surface of the target having the square substrate-facing surface, a front view of a fifth example regarding the position of the second rotation axis relative to the target and the corresponding open position of the second shutter plate in the target shutter mechanism according to the first embodiment.
Fig. 14 is a front view of a target shutter mechanism according to a third embodiment of the present invention and a target having a circular substrate-facing surface to be opened or closed by the target shutter mechanism.

### DESCRIPTION OF EMBODIMENTS

Preferable embodiments of the present invention will be described with reference to the drawings.

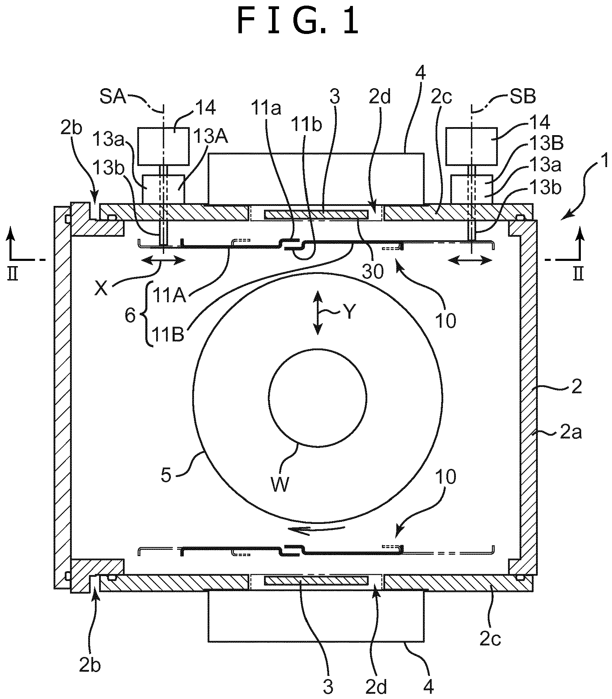

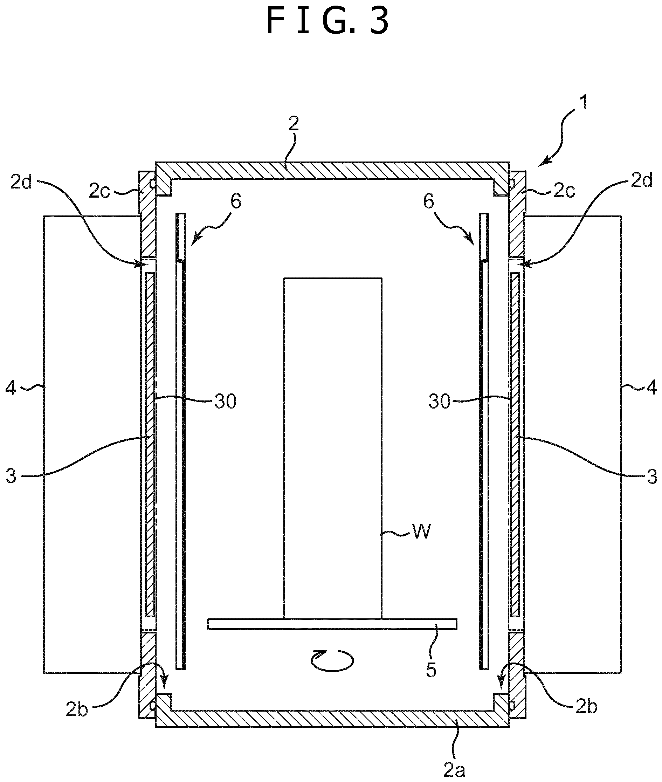

Figs. 1 to 3 illustrate a film-forming device 1 according to a first embodiment of the present invention. The film-forming device 1 is a device configured to form a film on a substrate W by sputtering, and includes a film-forming chamber 2 configured to house the substrate W, multiple targets 3, sputtering sources 4 configured to apply sputtering voltage to the targets 3, a substrate mounting portion 5 on which the substrate W is mounted, and multiple shutter mechanisms 10 having shutters 6 operable to open or close between each of the multiple targets 3 and the substrate W.

Each of the multiple targets 3 has a substrate-facing surface 30 facing the substrate W. In the film-forming device 1, voltage is applied from each of the sputtering sources 4 to a corresponding one of the multiple targets 3 in a state in which the inside of the film-forming chamber 2 is depressurized to the vicinity of vacuum, and in this manner, particles of a target material are released from the substrate-facing surface 30 of the target 3 to adhere to a surface of the substrate W. In this manner, a film made of a desired material is generated on the surface of the substrate W.

The multiple targets 3 are made of different materials (e.g., aluminum and titanium). The particles are released separately from each target 3 so that a film made of multiple types of materials can be formed using the single film-forming device 1. When the particles are released from one target 3, the shutters 6 of the shutter mechanisms 10 provided for other targets 3 are closed to cover the substrate-facing surfaces 30 of the other targets 3. In this manner, contamination of the substrate-facing surfaces 30 of the other targets 3 due to the particles is prevented. Moreover, pre-sputtering for a specific target 3 is performed in a state in which the shutter 6 for such a specific target 3 is closed, and in this manner, the substrate-facing surface 30 of the specific target 3 can be cleaned.

Hereinafter, each component of the film-forming device 1 will be described in more detail.

The film-forming chamber 2 has a hollow box-shaped main body 2a with multiple openings 2b, and multiple closing plates 2c attached to the main body 2a to open or close each opening 2b. The closing plate 2c may be a door panel configured to swing about a rotation axis extending in a direction perpendicular to the main body 2a or a panel detachable from the main body 2a. The target 3, the sputtering source 4, and the shutter mechanism 10 are attached to each closing plate 2c. Thus, when each closing plate 2c is opened, replacement and maintenance of the target 3 attached to the closing plate 2c and a first shutter plate 11A and a second shutter plate 11B of the shutter mechanism 10 attached to the closing plate 2c can be easily performed. The film-forming device 1 has such a compact configuration that the target 3, the sputtering source 4, and the shutter mechanism 10 are attached to each closing plate 2c as described above, and is extremely smaller than a typical sputtering device.

The substrate mounting portion 5 is, for example, a rotary table rotatably attached to the inside of the film-forming chamber 2, and is configured to support the substrate W such that the substrate W mounted on the substrate mounting portion 5 can rotate or revolve about a perpendicular axis.

Each of the multiple targets 3 is placed in the film-forming chamber 2 such that the substrate-facing surface 30 of the target 3 faces the substrate W. In the present embodiment, each of the closing plates 2c is provided with an attachment hole 2d, and the target 3 is placed in the attachment hole 2d. However, the target 3 may be placed at other locations in the film-forming chamber 2.

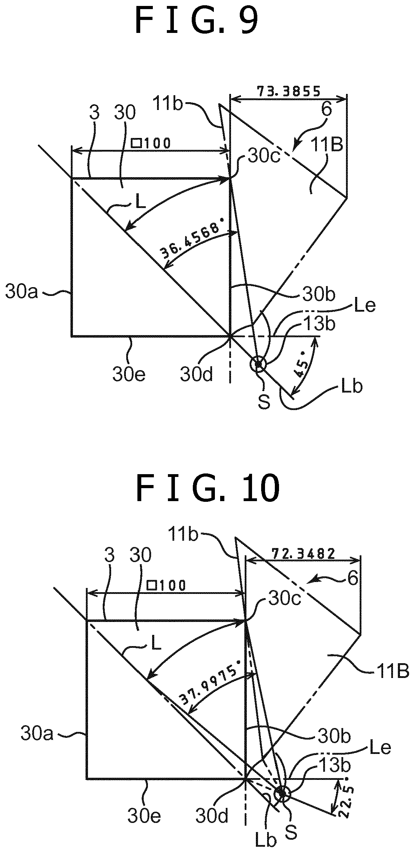

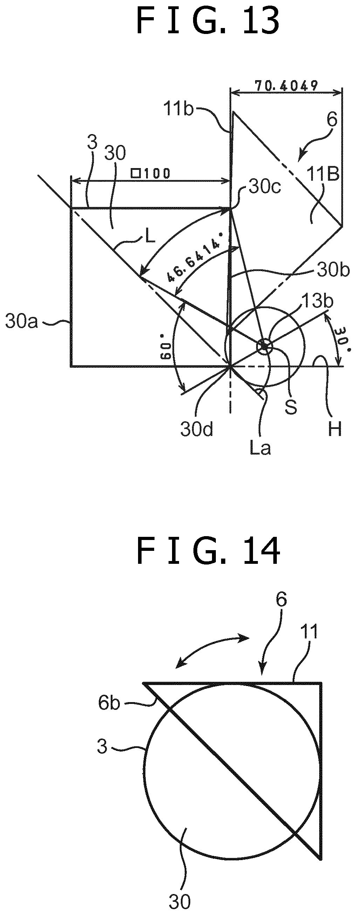

In the present embodiment, the substrate-facing surface 30 has a rectangular shape as viewed from the direction of a line normal to the substrate-facing surface 30, and has a first side 30a and a second side 30b as a pair of long sides facing each other and a pair of short sides 30s facing each other. The shape of the substrate-facing surface 30 is not specifically limited. The shape of the substrate-facing surface 30 as viewed from the normal direction of the substrate-facing surface 30 may be, for example, a square shape illustrated in Figs. 9 to 10 or a circular shape illustrated in Fig. 14.

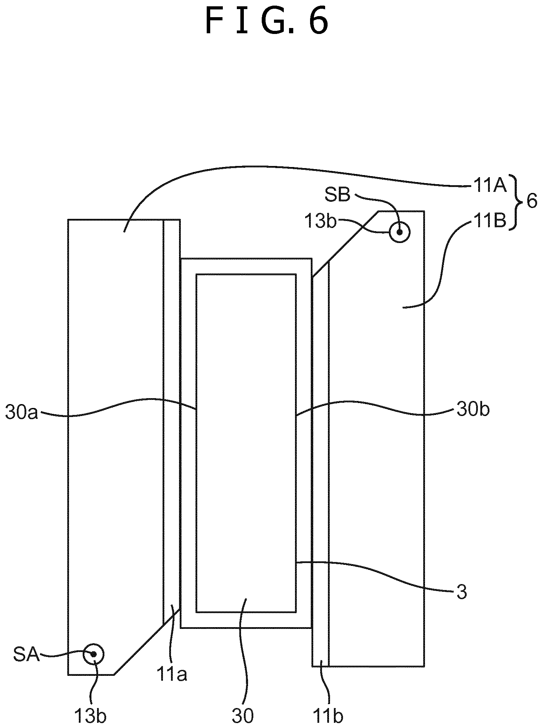

The shutter mechanism 10 is configured to openably cover the substrate-facing surface 30 of the target 3 with respect to the substrate W. The shutter mechanism 10 includes the first shutter plate 11A and the second shutter plate 11B rotatable in a direction X along the substrate-facing surface 30 to move between a closed position and an open position. The shutter mechanism 10 has a characteristic that the first and second shutter plates 11A, 11B are, for narrowing a retracting space for retracting each of the first and second shutter plates 11A, 11B to the open position, rotatably supported along an outer peripheral edge of the substrate-facing surface 30 of the target 3 at the open position illustrated in Fig. 6.

Specifically, in addition to the shutter 6 having the first shutter plate 11A and the second shutter plate 11B, the shutter mechanism 10 includes a first rotary support portion 13A, a second rotary support portion 13B, and a drive device as illustrated in Figs. 1 to 3.

The first shutter plate 11A and the second shutter plate 11B are, at a position between the substrate-facing surface 30 and the substrate W in the film-forming chamber 2, arranged to perform the opening/closing operation of moving in the direction X along the substrate-facing surface 30.

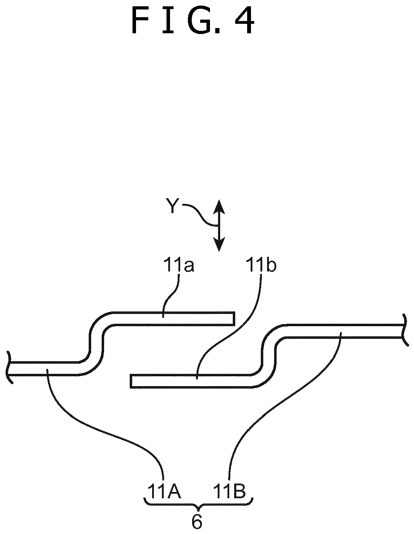

The first shutter plate 11A and the second shutter plate 11B have the same shape such as an elongated rectangular flat plate shape. The first shutter plate 11A and the second shutter plate 11B each have overlapping edge portions 11a, 11b as a first edge portion and a second edge portion. The overlapping edge portions 11a, 11b are edge portions close to each other at the position between the substrate-facing surface 30 and the substrate W, such as edge portions which can overlap with each other as viewed from the normal direction Y of the substrate-facing surface 30. As illustrated in Figs. 1 and 4, the overlapping edge portions 11a, 11b are portions having a predetermined width at the edges of the shutter plates 11A, 11B, and protrude from main body portions of the shutter plates 11A, 11B in opposite directions of the normal direction Y so that the overlapping edge portions 11a, 11b can overlap with each other as viewed from the normal direction Y in a state in which the overlapping edge portions 11a, 11b are separated from each other in the normal direction Y. The overlapping edge portions 11a, 11b may have such a shape that the overlapping edge portions 11a, 11b overlap with each other in the normal direction Y in a state in which the overlapping edge portions 11a, 11b slightly contact each other in the normal direction Y as long as there is no interference with opening or closing of the first shutter plate 11A and the second shutter plate 11B.

The first rotary support portion 13A supports the first shutter plate 11A such that the first shutter plate 11A is rotatable about a first rotation axis SA extending in the normal direction Y of the substrate-facing surface 30. The first rotary support portion 13A has a bearing 13a and a shaft 13b. The shaft 13b is fixed to the first shutter plate 11A, and is rotatably supported at the bearing 13a. The shaft 13b of the first rotary support portion 13A extends in the normal direction Y of the substrate-facing surface 30, and is arranged along the first rotation axis SA such that the shaft 13b is rotatable about the first rotation axis SA.

The second rotary support portion 13B supports the second shutter plate 11B such that the second shutter plate 11B is rotatable about a second rotation axis SB extending in the normal direction Y of the substrate-facing surface 30. The second rotary support portion 13B has a bearing 13a and a shaft 13b. The shaft 13b is fixed to the second shutter plate 11B, and is rotatably supported at the bearing 13a. The shaft 13b of the second rotary support portion 13B extends in the normal direction Y of the substrate-facing surface 30, and is arranged along the second rotation axis SB such that the shaft 13b is rotatable about the second rotation axis SB.

As long as the first rotary support portion 13A and the second rotary support portion 13B each rotatably support the first shutter plate 11A and the second shutter plate 11B, various modifications can be made to specific configurations of the first rotary support portion 13A and the second rotary support portion 13B. For example, these configurations are not limited to a configuration in which the shafts 13b are each fixed to the first shutter plate 11A and the second shutter plate 11B. For example, one of both end portions of the shaft 13b may be fixed to the film-forming chamber 2, and the other end portion may rotatably support each of the first shutter plate 11A and the second shutter plate 11B while penetrating each of the first shutter plate 11A and the second shutter plate 11B.

The drive device is configured to rotatably drive the first shutter plate 11A and the second shutter plate 11B about the first rotation axis SA and the second rotation axis SB. The drive device according to the present embodiment includes a first driver 14A and a second driver 14B configured to rotatably drive the shafts 13b each fixed to the first shutter plate 11A and the second shutter plate 11B, and the first and second drivers 14A, 14B are arranged outside the film-forming chamber 2. The drive device may include only a single drive source common to the shafts 13b of the first and second rotary support portions 13A, 13B.

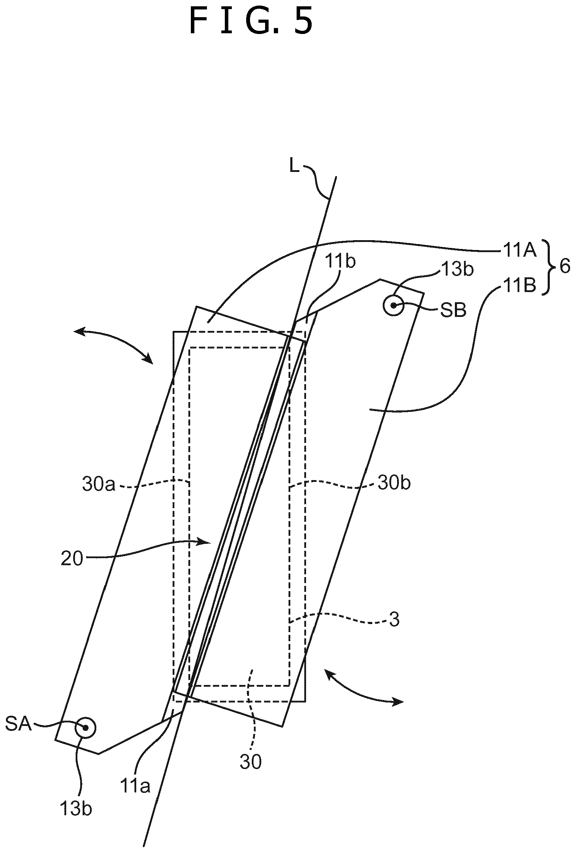

The first rotary support portion 13A and the second rotary support portion 13B each support the first shutter plate 11A and the second shutter plate 11B so that the first shutter plate 11A and the second shutter plate 11B can each rotate about the first rotation axis SA and the second rotation axis SB to rotate between the closed position illustrated in Fig. 5 and the open position illustrated in Fig. 6.

At the closed position illustrated in Fig. 5, the first shutter plate 11A and the second shutter plate 11B close the substrate-facing surface 30 from the substrate W in a state in which the overlapping edge portions 11a, 11b of the first shutter plate 11A and the second shutter plate 11B overlap with each other as viewed from the normal direction Y at the position between the substrate-facing surface 30 and the substrate W.

On the other hand, at the open position illustrated in Fig. 6, the first shutter plate 11A and the second shutter plate 11B open the substrate-facing surface 30 to the substrate W in such a manner that the overlapping edge portions 11a, 11b of the first shutter plate 11A and the second shutter plate 11B are separated from each other to retract from the position between the substrate-facing surface 30 and the substrate W in a direction parallel with the substrate-facing surface 30.

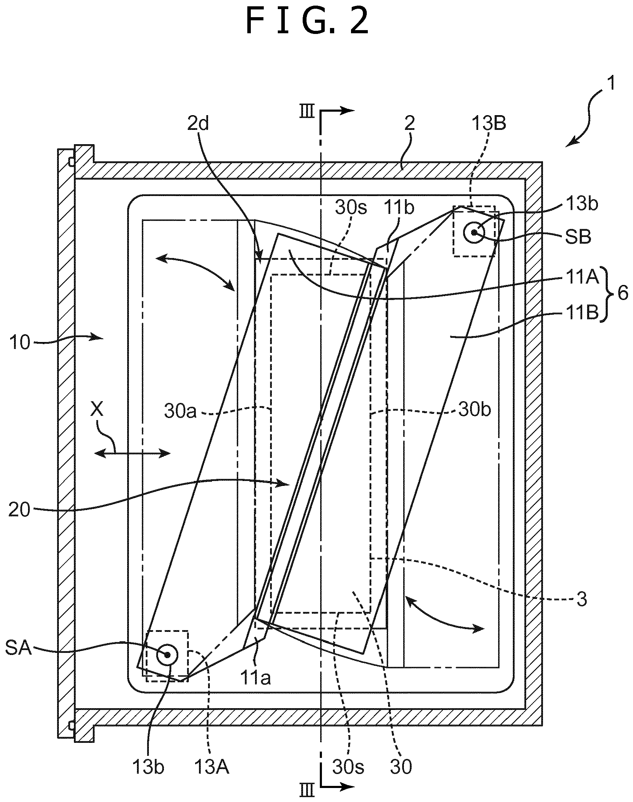

The first rotation axis SA and the second rotation axis SB are, as viewed from the normal direction Y of the substrate-facing surface 30, arranged on both sides of a closed position edge region 20 where the overlapping edge portions 11a, 11b of the first shutter plate 11A and the second shutter plate 11B overlap with each other at the closed position illustrated in Figs. 2 and 5. Further, the first rotation axis SA and the second rotation axis SB are arranged such that each of the overlapping edge portions 11a, 11b of the first shutter plate 11A and the second shutter plate 11B at the open position illustrated in Fig. 6 is along at least part (specifically, the first side 30a and the second side 30b as the pair of opposite long sides of the substrate-facing surface 30 of Fig. 6) of the outer peripheral edge of the substrate-facing surface 30.

Thus, the first shutter plate 11A and the second shutter plate 11B of the shutter mechanism 10 of the present embodiment are, at the open position illustrated in Fig. 6, dispersively arranged such that the overlapping edge portions 11a, 11b thereof are each along the first side 30a and the second side 30b as the pair of opposite long sides forming the outer peripheral edge of the substrate-facing surface 30. This can narrow a necessary retracting space for retracting the shutter 6 to the side of the target 3. That is, the retracting space for the shutter 6 in the film-forming chamber 2 can be narrowed as compared to a typical case, and therefore, size reduction in the film-forming chamber 2 can be realized.

Further, in the shutter mechanism 10 of the present embodiment, the first rotation axis SA and the second rotation axis SB are, as illustrated in Figs. 2 and 5 to 6, arranged on both sides of the substrate-facing surface 30 such that the substrate-facing surface 30 is sandwiched between the first rotation axis SA and the second rotation axis SB. With this arrangement, the first shutter plate 11A and the second shutter plate 11B can be dispersively arranged such that the overlapping edge portions 11a of the first shutter plate 11A and the second shutter plate 11B are, at the open position illustrated in Fig. 6, each along the first side 30a and the second side 30b as the opposite long sides of the outer peripheral edge of the substrate-facing surface 30 of the target 3. This can decrease a necessary rotation angle for moving the first shutter plate 11A and the second shutter plate 11B from the closed position to the open position, and therefore, can further narrow the retracting space for the shutter 6.

Further, in the shutter mechanism 10 of the present embodiment, in a case where the substrate-facing surface 30 of the target 3 has the rectangular shape as viewed from the normal direction Y of the substrate-facing surface 30 as illustrated in Fig. 5, the closed position edge region 20 in which the overlapping edge portions 11a, 11b as the first edge portion and the second edge portion of the first and second shutter plates 11A, 11B at the closed position overlap with each other is along one specific diagonal line L selected from two diagonal lines of the substrate-facing surface 30, and the first rotation axis SA and the second rotation axis SB are arranged on both sides of the specific diagonal line L. With such arrangement, when the first shutter plate 11A and the second shutter plate 11B has moved from the closed position illustrated in Fig. 5 to the open position illustrated in Fig. 6, the overlapping edge portions 11a, 11b can be dispersively arranged in a state in which the overlapping edge portions 11a, 11b extend parallel with each other along the first side 30a and the second side 30b as the pair of opposite long sides of the outer peripheral edge of the rectangular substrate-facing surface 30 of the target 3. This can decrease the necessary rotation angle for moving the first shutter plate 11A and the second shutter plate 11B from the closed position to the open position, and therefore, can narrow the necessary retracting space for the shutter 6 at the periphery of the target 3 having the rectangular substrate-facing surface 30.

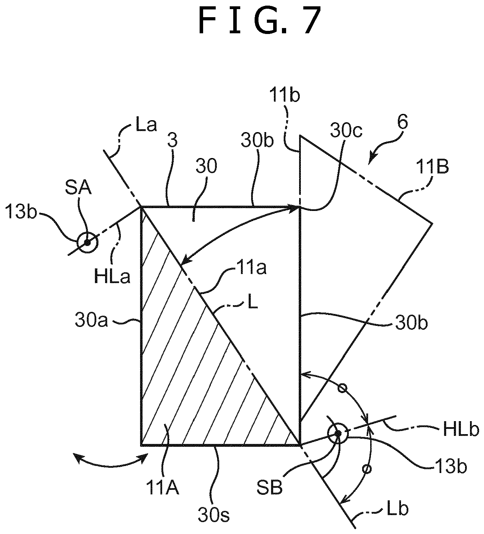

The first rotation axis SA and the second rotation axis SB are arranged such that the closed position edge region 20 in which the overlapping edge portions 11a, 11b overlap with each other as viewed from the normal direction Y is, as described above, along the specific diagonal line L of the rectangular substrate-facing surface 30. Further, as illustrated in Fig. 7, when the specific diagonal line L turns about the first and second rotation axes SA, SB as rotation centers, the specific diagonal line L is preferably at a position coincident with each of the opposite long sides in a pair.

Specifically, as illustrated in Fig. 7, the first rotation axis SA is preferably arranged on a half line HLa as viewed from the normal direction Y of the substrate-facing surface 30, and the second rotation axis SB is preferably arranged on a half line HLb. The half line HLa is a line bisecting an angle between the first side 30a of the pair of opposite long sides of the outer peripheral edge of the substrate-facing surface 30 and a first extended line La as an extended line of the specific diagonal line L from an intersection (an upper left corner portion in Fig. 7) between the specific diagonal line L and the first side 30a, and the half line HLb is a line bisecting an angle between the second side 30b of the pair of long sides and a second extended line Lb as an extended line of the specific diagonal line L from an intersection (a lower right corner portion in Fig. 7) between the specific diagonal line L and the second side 30b. With arrangement of the first and second rotation axes SA, SB, the specific diagonal line L can overlap with each of the first side 30a and the second side 30b when the specific diagonal line L turns about each of the first rotation axis SA and the second rotation axis SB as the rotation centers. With this configuration, when the first shutter plate 11A and the second shutter plate 11B are at the open position illustrated in Fig. 6, the overlapping edge portions 11a, 11b are reliably positioned to extend parallel with the first side 30a and the second side 30b as two opposite long sides of the outer peripheral edge of the substrate-facing surface 30 of the target 3. This can narrow the necessary retracting space for the shutter 6 at the periphery of the target 3 having the rectangular substrate-facing surface 30, and therefore, design of the shutter mechanisms 10 can be facilitated.

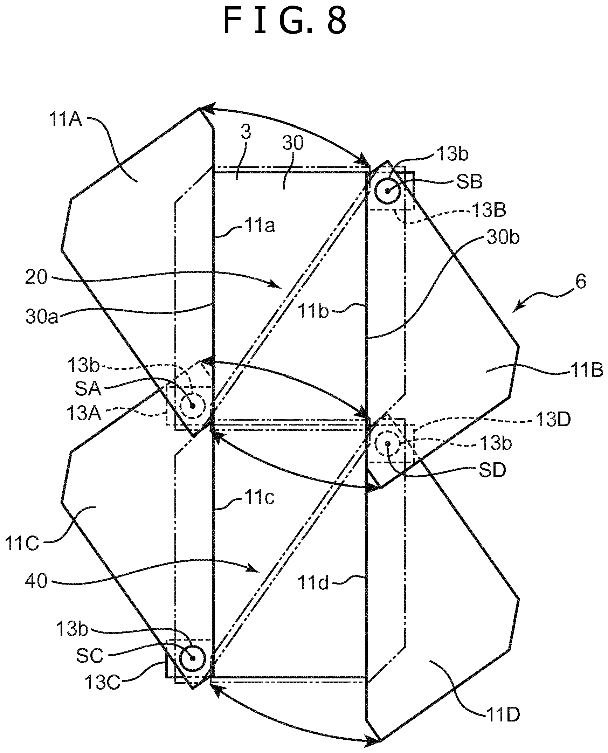

The shutter mechanism according to the present invention is not limited to one having only the pair of shutter plates 11A, 11B as in the shutter mechanism 10. A specific number of multiple shutter plates included in the shutter mechanism according to the present invention is not limited. Fig. 8 illustrates a shutter mechanism according to a second embodiment of the present invention as an example shutter mechanism including four shutter plates.

The shutter mechanism according to the second embodiment includes a shutter 6 illustrated in Fig. 8. The shutter 6 has a first shutter plate 11A, a second shutter plate 11B, a third shutter plate 11C, and a fourth shutter plate 11D. The first to fourth shutter plates 11A, 11B, 11C, 11D cooperate with each other to openably cover an elongated rectangular substrate-facing surface 30 of a target 3.

The first shutter plate 11A and the second shutter plate 11B have configurations similar to those of the above-described first shutter plate 11A and the above-described second shutter plate 11B illustrated in Figs. 1 to 3, and therefore, description thereof will be omitted.

As in the first shutter plate 11A and the second shutter plate 11B, the third shutter plate 11C and the fourth shutter plate 11D are movable in a direction X (see Fig. 1) along the substrate-facing surface 30 at a position between the substrate-facing surface 30 and a substrate W, and each have overlapping edge portions 11c, 11d as a third edge portion and a fourth edge portion which can be close to each other at the position between the substrate-facing surface 30 and the substrate W, such as a third edge portion and a fourth edge portion which can overlap with each other in a normal direction Y of the substrate-facing surface 30.

The third shutter plate 11C and the fourth shutter plate 11D are, at the position between the substrate-facing surface 30 and the substrate W, arranged at positions shifted from the first shutter plate 11A and the second shutter plate 11B in a direction (specifically, downward in Fig. 8) along the substrate-facing surface 30.

In addition to the above-described first rotary support portion 13A and the above-described second rotary support portion 13B, the shutter mechanism illustrated in Fig. 8 further includes a third rotary support portion 13C and a fourth rotary support portion 13D.

The third rotary support portion 13C supports the third shutter plate 11C such that the third shutter plate 11C is rotatable about a third rotation axis SC extending in the normal direction of the substrate-facing surface 30. The fourth rotary support portion 13D supports the fourth shutter plate 11D such that the fourth shutter plate 11D is rotatable about a fourth rotation axis SD extending in the normal direction of the substrate-facing surface 30. As in the first rotary support portion 13A and the second rotary support portion 13B, each of the third rotary support portion 13C and the fourth rotary support portion 13D has a shaft 13b and a not-shown bearing rotatably supporting the shaft 13b. The shaft 13b of the third rotary support portion 13C is fixed to the third shutter plate 11C, and the shaft 13b of the fourth rotary support portion 13D is fixed to the fourth shutter plate 11D.

The shutter mechanism according to the second embodiment includes a drive device configured to rotatably drive each of the first to fourth shutter plates 11A to 11D in an opening/closing direction. As in the first embodiment, the drive device has, in addition to a first driver configured to rotatably drive the first shutter plate 11A about the first rotation axis SA and a second driver configured to rotatably drive the second shutter plate 11B about the second rotation axis SB, a third driver configured to rotatably drive the third shutter plate 11C about the third rotation axis SC and a fourth driver configured to rotatably drive the fourth shutter plate 11D about the fourth rotation axis SD.

The third rotary support portion 13C and the fourth rotary support portion 13D each support the third shutter plate 11C and the fourth shutter plate 11D so that the third shutter plate 11C and the fourth shutter plate 11D can each rotate about the third rotation axis SC and the fourth rotation axis SD to rotate between a closed position indicated by a chain double-dashed line in Fig. 8 and an open position indicated by a solid line in Fig. 8. At the closed position, the third shutter plate 11C and the fourth shutter plate 11D close the substrate-facing surface 30 from the substrate W in a state in which the overlapping edge portions 11c, 11d of the third shutter plate 11C and the fourth shutter plate 11D overlap with each other at the position (see Fig. 1) between the substrate-facing surface 30 and the substrate W. At the open position, the third shutter plate 11C and the fourth shutter plate 11D retract from the position between the substrate-facing surface 30 and the substrate W in a direction along the substrate-facing surface such that the overlapping edge portions 11c, 11d are separated from each other.

The third rotation axis SC and the fourth rotation axis SD are arranged on both sides of a closed position edge region 40 in which the overlapping edge portions 11c, 11d overlap with each other at the closed position such that when each of the third shutter plate 11C and the fourth shutter plate 11D is at the open position, the overlapping edge portions 11c, 11d are along at least part (specifically, a first side 30a and a second side 30b as a pair of opposite long sides illustrated in Fig. 8) of an outer peripheral edge of the substrate-facing surface 30.

According to the shutter mechanism illustrated in Fig. 8, the substrate-facing surface 30 of the target 3 having a shape (e.g., an elongated rectangular shape) elongated in a specific direction can close, without any clearances, the first to fourth shutter plates 11A, 11B, 11C, 11D included in the shutter 6. Specifically, the first shutter plate 11A and the second shutter plate 11B overlap with each other in the above-described closed position edge region 20 diagonally crossing the substrate-facing surface 30, thereby covering the half (the upper half in Fig. 8) of the substrate-facing surface 30. Similarly, the third shutter plate 11C and the fourth shutter plate 11D overlap, at a position separated from the region 20 in the direction along the substrate-facing surface 30, with each other in the closed position edge region 40 diagonally crossing the substrate-facing surface 30, thereby covering the other half (the lower half in Fig. 8) of the substrate-facing surface 30. Further, when the second shutter plate 11B and the third shutter plate 11C positioned therebelow overlap with each other at the closed position, the substrate-facing surface 30 can be closed without any clearances not only in the regions 20, 40 but also in a region between the second and third shutter plates 11B, 11C.

In the shutter 6 illustrated in Fig. 8, the overlapping edge portions 11a, 11c as the first and third edge portions of the first and third shutter plates 11A, 11C can be, at the open position of each of the first to fourth shutter plates 11A, 11B, 11C, 11D, dispersively arranged along one side of the outer peripheral edge of the substrate-facing surface 30, specifically the first side 30a of the pair of long sides, and the overlapping edge portions 11b, 11d as the second and fourth edge portions of the second and fourth shutter plates 11B, 11D can be dispersively arranged along the other side of the outer peripheral edge of the substrate-facing surface 30, specifically the second side 30b of the pair of long sides. This can narrow a retracting space for the shutter 6 although the shutter 6 has the four shutter plates 11A, 11B, 11C, 11D.

In the shutter 6 illustrated in Fig. 8, part of the first shutter plate 11A and part of the third shutter plate 11C positioned therebelow overlap, at the open position of each of the first to fourth shutter plates 11A to 11D, with each other as viewed from the normal direction Y of the substrate-facing surface 30. Similarly, part of the second shutter plate 11B and part of the fourth shutter plate 11D positioned therebelow overlap with each other. Such partial overlap between the first shutter plate 11A and the third shutter plate 11C and such partial overlap between the second shutter plate 11B and the fourth shutter plate 11D can decrease the total area of the retracting space for the shutter 6 as viewed in the normal direction Y as compared to the total area of the first to fourth shutter plates 11A, 11B, 11C, 11D.

The substrate-facing surface 30 of the target 3 may be in a square shape illustrated in Figs. 9 to 13, for example. In this case, the positions of the rotation axes of the first and second shutter plates for minimizing the retracting space for the shutter 6 will be discussed as follows, focusing on the position of the second rotation axis SB of the second shutter plate 11B.

In the example illustrated in Figs. 9 to 13, the second shutter plate 11B has a portion having the same shape as that of a region formed by division of the square substrate-facing surface 30 along a specific diagonal line L as one of diagonal lines in a pair, i.e., a portion in an isosceles right triangular shape. The second shutter plate 11B has the overlapping edge portion 11b as the second edge portion coincident with the specific diagonal line L at the closed position. For rotatably supporting the second shutter plate 11B, the shaft 13b of the second rotary support portion fixed to the second shutter plate 11B has the center coincident with the second rotation axis SB. In the example illustrated in Figs. 9 to 13, any of four sides of the substrate-facing surface 30 including the second side 30b has a length of 100 mm.

Fig. 9 illustrates a state when the second shutter plate 11B reaches such an open position that the second shutter plate 11B has rotated about the second rotation axis SB to retract from the substrate-facing surface 30, i.e., such a position that a line corresponding to the overlapping edge portion 11b of the second shutter plate 11B as viewed from the normal direction Y of the substrate-facing surface 30 passes through an upper right corner portion 30c of the substrate-facing surface 30, in a case where the second rotation axis SB is positioned on a second extended line La of the specific diagonal line L. A rotation angle between the overlapping edge portion 11b of the second shutter plate 11B and the specific diagonal line L in this state is 36.4568 degrees, and a horizontal distance, i.e., a retracting distance, from a portion (a corner portion at a right end in Fig. 9) of the second shutter plate 11B farthest from the substrate-facing surface 30 to the corner portion 30c of the substrate-facing surface 30 is 73.3855 mm.

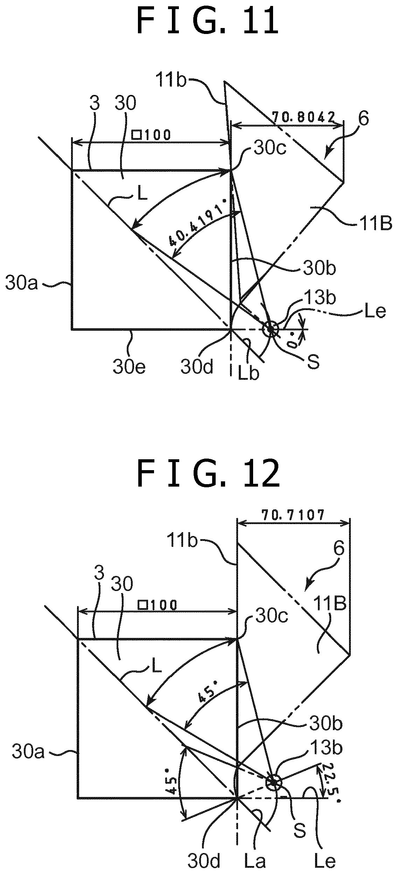

Figs. 10 and 11 illustrate a case where the second rotation axis SB is at a position upwardly separated from a second extended line Lb of the specific diagonal line L, i.e., a position separated from the second extended line Lb toward the second shutter plate 11B. Specifically, as viewed from the normal direction Y, the second rotation axis SB is, in Fig. 10, positioned between the second extended line Lb and a reference line H as an extended line (in the example illustrated in Figs. 9 to 13, a horizontal line) from a lower right corner portion 30d of a lower side 30e of the square substrate-facing surface 30. In Fig. 11, the second rotation axis SB is positioned on the reference line H. In these cases, as the second rotation axis SB is separated from the second extended line Lb, a necessary rotation angle for opening or closing increases, but the retracting distance decreases. The retracting distance corresponds to the width of the retracting space for the shutter 6, and therefore, it is assumed that the retracting space for the shutter 6 is narrowed as the second rotation axis SB is separated from the second extended line Lb in an area illustrated in Figs. 9 to 11.

Fig. 12 illustrates a case where the second rotation axis SB is positioned further above the reference line H and an angle between a line Ls connecting the second rotation axis SB and the lower right corner portion 30d and the reference line H is 22.5 degrees. In this case, the specific diagonal line L turns 45 degrees in a clockwise direction (i.e., a direction toward the second side 30b of the substrate-facing surface 30) about the second rotation axis SB as viewed from the normal direction Y, thereby reaching a position coincident with the second side 30b. Thus, the second shutter plate 11B can rotate 45 degrees about the second rotation axis SB to move from the closed position at which the overlapping edge portion 11b of the second shutter plate 11B is coincident with the specific diagonal line L of the substrate-facing surface 30 to the open position at which the overlapping edge portion 11b is along the second side 30a. The retracting distance of the second shutter plate 11B in this case is 70.7107 mm, and is shorter than that in the case illustrated in Figs. 9 to 11.

However, as illustrated in Fig. 13, in a case where a rotation axis S is at a position further above the position illustrated in Fig. 12, specifically the line Ls connecting the second rotation axis SB and the lower right corner portion 30d is at a position separated upwardly from the reference line H by 30 degrees, part of the second shutter plate 11B overlaps with the substrate-facing surface 30 even when the second shutter plate 11B opens to such a position that the overlapping edge portion 11b thereof overlaps with the upper right corner portion 30c of the substrate-facing surface 30 as viewed from the normal direction Y as illustrated in Fig. 13. Thus, for fully opening the substrate-facing surface 30, the second shutter plate 11B needs to be rotated about the second rotation axis S in a direction apart from the substrate-facing surface 30. This prevents narrowing of the retracting space for the shutter 6.

Discussion above reaches the following conclusion. That is, for the shutter 6 configured to open or close the substrate-facing surface 30 having the square shape as viewed from the normal direction Y, the position of the second rotation axis SB as illustrated in Fig. 12, i.e., the position at which the angle between the line Ls connecting the second rotation axis SB and the lower right corner portion 30d and the reference line H is 22.5 degrees, can minimize the retracting space for the shutter 6.

As in the position of the second rotation axis SB for opening or closing the substrate-facing surface 30 having the elongated rectangular shape as illustrated in Fig. 7, the position of the second rotation axis SB illustrated in Fig. 12 corresponds to the position on the half line bisecting the angle between the second extended line Lb of the specific diagonal line L and the second side 30b of the substrate-facing surface 30 as viewed from the normal direction Y. Similarly, for the position of the first rotation axis SA, the first rotation axis SA is positioned on the half line bisecting the angle between the first extended line La of the specific diagonal line L and the first side 30a of the substrate-facing surface 30 as viewed from the normal direction Y, and therefore, the retracting space for the shutter 6 is minimized.

A specific shape of the substrate-facing surface 30 of the target 3 as viewed from the normal direction is not limited. Such a shape may be a circular shape as illustrated in Fig. 14. In the case of such a circular substrate-facing surface 30, use of a shutter 6 having a shutter plate 11 in an isosceles right triangular shape formed by bisecting of a square externally tangent to the circular outline of the substrate-facing surface 30 along a diagonal line of the square as viewed from the normal direction of the substrate-facing surface 30 as illustrated in Fig. 14 can narrow the retracting space for the shutter 6 as in the case of the substrate-facing surface 30 in the square shape as illustrated in Fig. 12, for example.

In the embodiments above, the first and second edge portions of the first shutter plate 11A and the second shutter plate 11B at the closed position, i.e., the edge portions close to each other at the position between the substrate-facing surface 30 of the target 3 and the substrate W, are the overlapping edge portions 11a, 11b overlapping with each other in the normal direction Y of the substrate-facing surface 30 at the position between the substrate-facing surface 30 and the substrate W, but the present invention is not limited to above.

The present invention also includes an aspect that opposite surfaces (end surfaces) of the first shutter plate 11A and the second shutter plate 11B at the closed position contact each other at the position between the substrate-facing surface 30 and the substrate W. The shutter mechanism according to this aspect can narrow the retracting space for the shutter with a simple configuration, and therefore, can realize size reduction in the film-forming chamber in the film-forming device.

As in the above-described case, in the shutter mechanism including the third shutter plate 11C and the fourth shutter plate 11D in addition to the first shutter plate 11A and the second shutter plate 11B as illustrated in Fig. 8, opposite surfaces (end surfaces) of the third and fourth edge portions of the third shutter plate 11C and the fourth shutter plate 11D at the closed position may contact each other at the position between the substrate-facing surface 30 and the substrate W. In this case, advantageous effects similar to those of the above-described embodiments can be provided.

As described above, the target shutter mechanism including the shutter configured to openably cover the target used for sputtering is provided, and can narrow the retracting space for retracting the shutter from the target to the open position without the need for a complicated structure.

Provided is the shutter mechanism for openably covering the target used for sputtering and having the substrate-facing surface facing the substrate on which the film is formed by sputtering. The shutter mechanism includes the shutter configured movable in the direction along the substrate-facing surface at the position between the substrate-facing surface and the substrate and having the first shutter plate and the second shutter plate, the first shutter plate and the second shutter plate each having the first edge portion and the second edge portion contactable each other or approachable to each other at the position between the substrate-facing surface and the substrate; the first rotary support portion configured to support the first shutter plate such that the first shutter plate is rotatable about the first rotation axis extending in the normal direction of the substrate-facing surface; the second rotary support portion configured to support the second shutter plate such that the second shutter plate is rotatable about the second rotation axis extending in the normal direction of the substrate-facing surface; and the drive device configured to rotatably drive the first shutter plate and the second shutter plate about the first rotation axis and the second rotation axis. The first rotary support portion and the second rotary support portion rotatably support the first shutter plate and the second shutter plate such that transition is, by rotation of the first shutter plate and the second shutter plate about the first rotation axis and the second rotation axis, made between the closed position at which the first shutter plate and the second shutter plate close the substrate-facing surface with the first edge portion and the second edge portion contacting each other or being close to each other at the position between the substrate-facing surface and the substrate and the open position at which the substrate-facing surface is opened to the substrate in such a manner that each of the first shutter plate and the second shutter plate retracts from the position between the substrate-facing surface and the substrate such that the first edge portion and the second edge portion are separated from each other. The first rotation axis and the second rotation axis are arranged on both sides of the closed position edge region such that the first edge portion and the second edge portion are along at least part of the outer peripheral edge of the substrate-facing surface at the open position, the closed position edge region being a region where the first edge portion and the second edge portion contact each other or are close to each other when the first shutter plate and the second shutter plate are at the closed position.

In the shutter mechanism, the first and second shutter plates forming the shutter open or close the substrate-facing surface with respect to the substrate by the simple operation of rotating in the direction along the substrate-facing surface of the target, and when each shutter plate is at the open position, the first and second edge portions are dispersively arranged along the outer peripheral edge of the substrate-facing surface of the target. That is, the first and second shutter plates rotate, in response to rotary drive force of the driver, about the first rotation axis and the second rotation axis in the direction along the substrate-facing surface, and therefore, transition between the closed position at which the first and second edge portions contact each other or are close to each other and the open position at which the first and second edge portions retract from the substrate-facing surface of the target.

The first and second rotation axes described herein are arranged on both sides of the closed position edge region such that when the first shutter plate and the second shutter plate are at the open position, the first edge portion and the second edge portion are along at least part of the outer peripheral edge of the substrate-facing surface. With this arrangement, the first shutter plate and the second shutter plate can be, at the open position, dispersively arranged in a state in which the edge portions thereof are along the outer peripheral edge of the substrate-facing surface. This eliminates the necessity of ensuring a large space for retracting the shutter to the open position at the side of the target. That is, the retracting space for the shutter can be narrowed.

The first rotation axis and the second rotation axis are preferably arranged on both sides of the substrate-facing surface with the substrate-facing surface being sandwiched between the first rotation axis and the second rotation axis such that the first edge portion and the second edge portion of the first shutter plate and the second shutter plate at the open position are each along the opposite portions of the outer peripheral edge of the substrate-facing surface of the target.

With arrangement of the first and second rotation axes, the rotation angle of the first shutter plate and the second shutter plate from the closed position to the open position can be decreased, and therefore, the retracting space for the shutter can be further narrowed.

Specifically, the substrate-facing surface of the target preferably has the rectangular shape, the first shutter plate and the second shutter plate are preferably arranged such that the closed position edge region is along the specific diagonal line selected from two diagonal lines of the substrate-facing surface as viewed from the normal direction of the substrate-facing surface, and the first rotation axis and the second rotation axis are preferably arranged on both sides of the specific diagonal line.

The first and second shutter plates arranged as described above merely rotate between the closed position at which the first and second edge portions contact each other or are close to each other in the closed position edge region along the specific diagonal line of the rectangular substrate-facing surface of the target and the open position at which the first and second edge portions are arranged to extend parallel along two opposite sides of the outer peripheral edge of the substrate-facing surface, thereby opening or closing the substrate-facing surface. This can decrease the rotation angle of the first shutter plate and the second shutter plate between the closed position and the open position, and therefore, can further narrow the retracting space for the shutter at the periphery of the target.

The first rotation axis is, as viewed from the normal direction of the substrate-facing surface, preferably arranged on the half line bisecting the angle between the extended line of the specific diagonal line and the first side of two opposite sides of the outer peripheral edge of the substrate-facing surface, and the second rotation axis is preferably arranged on the half line bisecting the angle between the extended line of the single specific diagonal line and the second side opposite to the first side of two opposite sides of the outer peripheral edge of the substrate-facing surface.

Arrangement of the first rotation axis and the second rotation axis is in such a position relationship that the specific diagonal line overlaps with each of the first side and the second side when the specific diagonal line turns about the first and second rotation axes. With such arrangement, when the first shutter plate and the second shutter plate are at the open position, the first and second edge portions are reliably positioned to extend parallel with each other along the first and second sides. Thus, such arrangement can easily and reliably provide the shutter mechanism having the further-narrowed retracting space for the shutter at the periphery of the target having the rectangular substrate-facing surface, and can facilitate design of the shutter mechanism.

The shutter preferably further includes the third shutter plate and the fourth shutter plate configured movable in the direction along the substrate-facing surface at the position between the substrate-facing surface and the substrate and each having the third edge portion and the fourth edge portion contactable each other or approachable to each other at the position between the substrate-facing surface and the substrate. The third shutter plate and the fourth shutter plate are preferably arranged at the positions shifted from the first shutter plate and the second shutter plate in the direction along the substrate-facing surface at the position between the substrate-facing surface and the substrate, and the first shutter plate, the second shutter plate, the third shutter plate, and the fourth shutter plate preferably form the shutter for opening or closing between the substrate-facing surface and the substrate. The shutter mechanism preferably further includes the third rotary support portion configured to support the third shutter plate such that the third shutter plate is rotatable about the third rotation axis extending in the normal direction of the substrate-facing surface and the fourth rotary support portion configured to support the fourth shutter plate such that the fourth shutter plate is rotatable about the fourth rotation axis extending in the normal direction of the substrate-facing surface. The driver preferably rotatably drives the third shutter plate and the fourth shutter plate about the third rotation axis and the fourth rotation axis. The third rotary support portion and the fourth rotary support portion preferably rotatably support the third shutter plate and the fourth shutter plate such that transition is, by rotation of the third shutter plate and the fourth shutter plate about the third rotation axis and the fourth rotation axis, made between the closed position at which the third shutter plate and the fourth shutter plate close the substrate-facing surface with the third edge portion and the fourth edge portion contacting each other or being close to each other at the position between the substrate-facing surface and the substrate and the open position at which each of the third shutter plate and the fourth shutter plate retracts from the position between the substrate-facing surface and the substrate such that the third edge portion and the fourth edge portion are separated from each other. The third rotation axis and the fourth rotation axis are preferably arranged on both sides of the region where the third edge portion and the fourth edge portion contact each other or are close to each other at the closed position such that the third edge portion and the fourth edge portion are along at least part of the outer peripheral edge of the substrate-facing surface at the open position.

Since the shutter includes the first to fourth shutter plates, the substrate-facing surface can be effectively closed even in a case where the substrate-facing surface of the target is in the shape (e.g., the elongated rectangular shape) elongated in the specific direction. In addition, the first to fourth shutter plates can be, at the open position, dispersively arranged such that the first to fourth edge portions are each along the outer peripheral edge of the substrate-facing surface. That is, the shutter mechanism can narrow the retracting space for the shutter even though the shutter mechanism includes the first to fourth shutter plates.

Provided is a film-forming device including the film-forming chamber configured to house the substrate, the target having the substrate-facing surface and placed in the film-forming chamber such that the substrate-facing surface faces the substrate, and the above-described shutter mechanism configured to open or close the substrate-facing surface with respect to the substrate. The first shutter plate and the second shutter plate of the shutter mechanism are openably arranged at the position between the substrate-facing surface and the substrate in the film-forming chamber.

Even though the first shutter plate and the second shutter plate in the film-forming device are openably arranged at the position between the substrate-facing surface and the substrate in the film-forming chamber, the first and second edge portions can be, at the open position, dispersively arranged along the outer peripheral edge of the substrate-facing surface. This can narrow the retracting space for the shutter in the film-forming chamber, and therefore, can reduce the size of the film-forming chamber.

## Claims

1. A target shutter mechanism for openably covering a target used for sputtering and having a substrate-facing surface facing a substrate on which a film is formed by the sputtering, comprising:
a shutter configured movable in a direction along the substrate-facing surface at a position between the substrate-facing surface and the substrate and having a first shutter plate and a second shutter plate, the first shutter plate and the second shutter plate each having a first edge portion and a second edge portion contactable each other or approachable to each other at the position between the substrate-facing surface and the substrate;
a first rotary support portion configured to support the first shutter plate such that the first shutter plate is rotatable about a first rotation axis extending in a normal direction of the substrate-facing surface;
a second rotary support portion configured to support the second shutter plate such that the second shutter plate is rotatable about a second rotation axis extending in the normal direction of the substrate-facing surface; and
a drive device configured to rotatably drive the first shutter plate and the second shutter plate about the first rotation axis and the second rotation axis,
wherein the first rotary support portion and the second rotary support portion rotatably support the first shutter plate and the second shutter plate such that transition is, by rotation of the first shutter plate and the second shutter plate about the first rotation axis and the second rotation axis, made between a closed position at which the first shutter plate and the second shutter plate close the substrate-facing surface with the first edge portion and the second edge portion contacting each other or being close to each other at the position between the substrate-facing surface and the substrate and an open position at which the substrate-facing surface is opened to the substrate in such a manner that each of the first shutter plate and the second shutter plate retracts from the position between the substrate-facing surface and the substrate such that the first edge portion and the second edge portion are separated from each other, and
the first rotation axis and the second rotation axis are arranged on both sides of a closed position edge region such that the first edge portion and the second edge portion are along at least part of an outer peripheral edge of the substrate-facing surface at the open position, the closed position edge region being a region where the first edge portion and the second edge portion contact each other or are close to each other when the first shutter plate and the second shutter plate are at the closed position.

2. The target shutter mechanism according to claim 1,
wherein the first rotation axis and the second rotation axis are arranged on both sides of the substrate-facing surface with the substrate-facing surface being sandwiched between the first rotation axis and the second rotation axis such that the first edge portion and the second edge portion of the first shutter plate and the second shutter plate at the open position are each along opposite portions of the outer peripheral edge of the substrate-facing surface of the target.

3. The target shutter mechanism according to claim 2,
wherein the substrate-facing surface of the target has a rectangular shape, the first shutter plate and the second shutter plate are arranged such that the closed position edge region is along a specific diagonal line selected from two diagonal lines of the substrate-facing surface as viewed from the normal direction of the substrate-facing surface, and the first rotation axis and the second rotation axis are arranged on both sides of the specific diagonal line.

4. The target shutter mechanism according to claim 3,
wherein the first rotation axis is, as viewed from the normal direction of the substrate-facing surface, arranged on a half line bisecting an angle between an extended line of the specific diagonal line and a first side of two opposite sides of the outer peripheral edge of the substrate-facing surface, and the second rotation axis is arranged on a half line bisecting an angle between an extended line of the single specific diagonal line and a second side opposite to the first side of the two opposite sides of the outer peripheral edge of the substrate-facing surface.

5. The target shutter mechanism according to claim 1,
wherein the shutter further includes a third shutter plate and a fourth shutter plate configured movable in the direction along the substrate-facing surface at the position between the substrate-facing surface and the substrate and each having a third edge portion and a fourth edge portion contactable each other or approachable to each other at the position between the substrate-facing surface and the substrate,
the third shutter plate and the fourth shutter plate are arranged at positions shifted from the first shutter plate and the second shutter plate in the direction along the substrate-facing surface at the position between the substrate-facing surface and the substrate, and the first shutter plate, the second shutter plate, the third shutter plate, and the fourth shutter plate form the shutter for opening or closing between the substrate-facing surface and the substrate,
the shutter mechanism further includes a third rotary support portion configured to support the third shutter plate such that the third shutter plate is rotatable about a third rotation axis extending in the normal direction of the substrate-facing surface and a fourth rotary support portion configured to support the fourth shutter plate such that the fourth shutter plate is rotatable about a fourth rotation axis extending in the normal direction of the substrate-facing surface,
the driver rotatably drives the third shutter plate and the fourth shutter plate about the third rotation axis and the fourth rotation axis,
the third rotary support portion and the fourth rotary support portion rotatably support the third shutter plate and the fourth shutter plate such that transition is, by rotation of the third shutter plate and the fourth shutter plate about the third rotation axis and the fourth rotation axis, made between a closed position at which the third shutter plate and the fourth shutter plate close the substrate-facing surface with the third edge portion and the fourth edge portion contacting each other or being close to each other at the position between the substrate-facing surface and the substrate and an open position at which each of the third shutter plate and the fourth shutter plate retracts from the position between the substrate-facing surface and the substrate such that the third edge portion and the fourth edge portion are separated from each other, and
the third rotation axis and the fourth rotation axis are arranged on both sides of a region where the third edge portion and the fourth edge portion contact each other or are close to each other at the closed position such that the third edge portion and the fourth edge portion are along at least part of the outer peripheral edge of the substrate-facing surface at the open position.

6. A film-forming device comprising:
a film-forming chamber configured to house a substrate;
a target having a substrate-facing surface and placed in the film-forming chamber such that the substrate-facing surface faces the substrate; and
the target shutter mechanism according any one of claims 1 to 5, the target shutter mechanism being configured to open or close the substrate-facing surface with respect to the substrate,
wherein the first shutter plate and the second shutter plate of the shutter mechanism are openably arranged at a position between the substrate-facing surface and the substrate in the film-forming chamber.
